# EUROPEAN PATENT SPECIFICATION

(11) **EP 2 930 845 B1**
(45) Date of publication and mention of the grant of the patent: **25.10.2017**
(21) Application number: 13870550.4
(22) Date of filing: 26.08.2013
(51) Int. Cl.: H03H 9/56, H03H 9/60, H03H 9/64

(54) **LOW-INSERTION-LOSS PIEZOELECTRIC ACOUSTIC WAVE BAND-PASS FILTER AND REALIZATION METHOD THEREOF**
MIT AKUSTISCHEN WELLEN ARBEITENDES PIEZOELEKTRISCHES BANDPASSFILTER MIT GERINGEM EINFÜGUNGSVERLUST UND AUSFÜHRUNGSVERFAHREN DAFÜR
FILTRE PASSE-BANDE À ONDE ACOUSTIQUE PIÉZOÉLECTRIQUE À FAIBLE PERTE D'INSERTION ET SON PROCÉDÉ DE RÉALISATION

(30) Priority: 11.01.2013 CN 201310010233
(43) Date of publication of application: 14.10.2015
(73) Proprietor: ZTE Corporation, Shenzhen, Guangdong 518057 (CN); Tianjin University, Tianjin 300072 (CN)
(72) Inventor: ZHANG, Hao, Tianjin 300072 (CN); DU, Liangzhen, Shenzhen Guangdong 518057 (CN); PANG, Wei, Tianjin 300072 (CN); LU, Yong, Shenzhen Guangdong 518057 (CN); QI, Mingke, Tianjin 300072 (CN); LIANG, Guangming, Shenzhen Guangdong 518057 (CN)
(74) Representative: D'Halleweyn, Nele Veerle Trees Gertrudis
(86) International application number: PCT/CN2013/082288
(87) International publication number: WO 2014/107962

(56) References cited:
- EP-A1- 2 299 595
- EP-A2- 1 478 091
- WO-A2-02/054592
- WO-A2-2012/052414
- CN-A- 1 864 326
- CN-A- 1 929 304
- US-A1- 2004 130 411
- US-A1- 2009 079 521
- GIRAUD S ET AL: "Bulk acoustic wave filters synthesis and optimization for multi-standard communication terminals", IEEE TRANSACTIONS ON ULTRASONICS, FERROELECTRICS AND FREQUENCY CONTROL, IEEE, US, vol. 56, no. 1, 1 January 2010 (2010-01-01), pages 52-58, XP011286741, ISSN: 0885-3010
- FATTINGER G G ET AL: "Optimization of acoustic dispersion for high performance thin film BAW resonators", ULTRASONICS SYMPOSIUM, 2005 IEEE ROTTERDAM, THE NETHERLANDS 18-21 SEPT. 2005, PISCATAWAY, NJ, USA,IEEE, vol. 2, 18 September 2005 (2005-09-18), pages 1175-1178, XP010899034, DOI: 10.1109/ULTSYM.2005.1603060 ISBN: 978-0-7803-9382-0

## Description

### Technical Field

The present invention relates to a piezoelectric acoustic wave band-pass filter, and particularly, to a circuit structure that can make the passband insertion loss of the band-pass filter be lower than that of a traditionally structured band-pass filter and a related realization method thereof.

### Background of the Related Art

Hand-held mobile communication products are being rapidly developed to miniaturization and portability, and with the decrease in sizes of these products, the prices are also fallen continuously, but the functions are strengthened gradually. In the wave of the development of miniaturization, as a critical component of a wireless communication system, a high-performance radio-frequency filter plays an extremely important role. Filter manufacturers are confronted with a task of further reducing the volume of the filter in a premise of not changing but even improving the performance of the filter. Moreover, due to an ever increasing number of various energy-consuming applications and devices in the hand-held mobile communication products, it makes a low insertion loss of the filter become very important for extending the call duration and battery life.

A topological structure in which a radio-frequency filter circuit is designed by using a resonator mainly includes a trapezoidal structure and a latticed structure, and in the design of the high-performance radio-frequency filter, the design method of the trapezoidal structure is more prevalent at present. A Bulk Acoustic Wave (BAW) resonator is a piezoelectric acoustic wave resonator, and it mainly includes a Film Bulk Acoustic Resonator (FBAR) and a Solid Mounted Resonator (SMR). The bulk acoustic wave resonator is famous for its high quality factor, and a band-pass filter containing one or more than one bulk acoustic wave resonator has become a strong competitor to the traditional filtering technique based on a Surface Acoustic Wave (SAW) resonator and a Ceramic resonator.

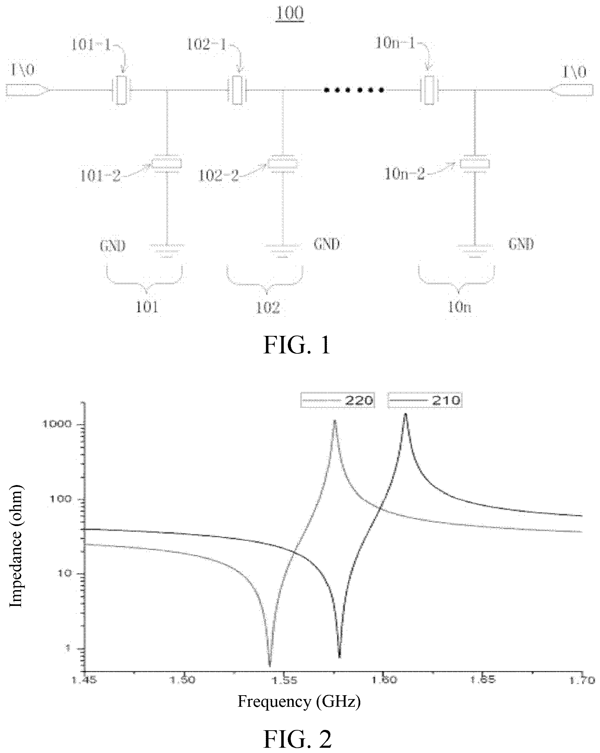

FIG. 1 shows a traditional acoustic wave band-pass filter 100 with the trapezoidal structure, and it consists of cascaded acoustic wave band-pass filter units 101, 102, ......, 10n. The acoustic wave band-pass filter unit 101 includes a series resonator 101-1 connected on a series branch and a parallel resonator 101-2 connected on a parallel branch. The acoustic wave band-pass filter units 102, 103, ..., 10n are similar to the acoustic wave band-pass filter unit 101. The series resonators 101-1, 102-1, ..., 10n-1 and the parallel resonators 101-2, 102-2, ... 10n-2 constituting the acoustic wave band-pass filter units 101, 102, ..., 10n in FIG. 1 can be Film Bulk Acoustic Resonators (FBAR) or Solid Mounted Resonators (SMR).

FIG. 2 shows frequency response curves of the series resonator 101-1 and the parallel resonator 101-2 in FIG. 1, wherein a curve 210 is a frequency response curve of the series resonator 101-1 in FIG. 1, and a curve 220 is a frequency response curve of the parallel resonator 101-2 in FIG. 1. In FIG. 2, an abscissa represents a frequency, and an ordinate represents an impedance value. A frequency of the resonator 101-1 when the impedance reaches the minimum is defined as a series resonant frequency fs101-1, and a frequency when the impedance reaches the maximum is defined as a parallel resonant frequency fp101-1; a frequency of the parallel resonator 101-2 when the impedance reaches the minimum is defined as a series resonant frequency fs101-2, and a frequency when the impedance reaches the maximum is defined as a parallel resonant frequency fp101-2. In the machining process, a frequency tuning layer is added in the parallel resonator 101-2, so that the fs101-2 is less than the fs101-1, the fp101-2 is less than the fp101-1, and the fp101-2 is equal to or approximate to the fs101-1. When the acoustic wave band-pass filter is designed, in the traditional acoustic wave band-pass filter 100 with the trapezoidal structure as shown in FIG. 1, the series resonant frequencies and parallel resonant frequencies of all the series resonators on the series branch are identical, and the series resonant frequencies and parallel resonant frequencies of all the parallel resonators on the parallel branch are identical.

If the acoustic wave resonator is within the range of the series resonant frequency and parallel resonant frequency, the resonator is equivalent to a high quality factor inductance, and if it is beyond the series resonant frequency and parallel resonant frequency, it is equivalent to a high quality factor capacitance.

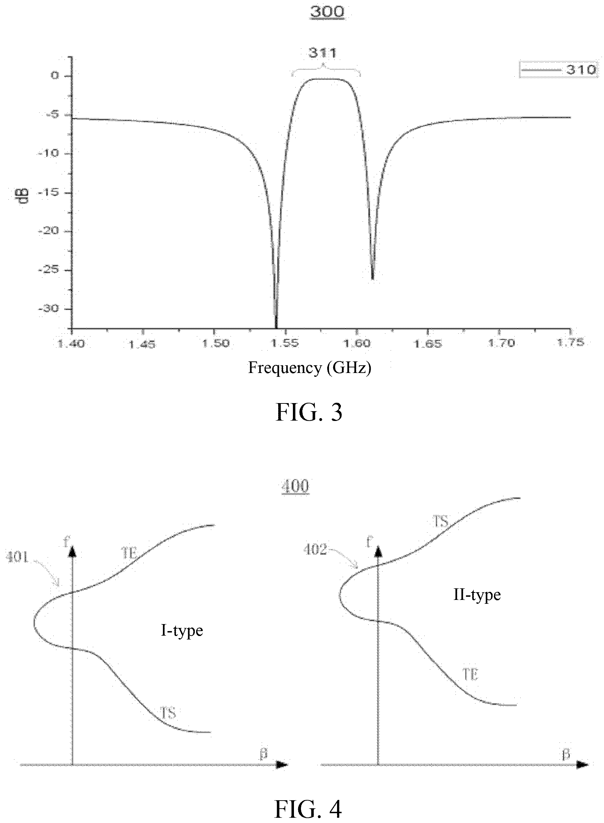

The curve shown in FIG. 3 is a frequency response curve of the piezoelectric acoustic wave band-pass filter unit 101 with the trapezoidal structure formed by the series resonator 101-1 and the parallel resonator 101-2. By designing a stacked structure of the resonators, the parallel resonant frequency fp101-2 of the parallel resonator 101-2 is equal to or approximate to the series resonant frequency fs101-1 of the series resonator 101-1. When an input signal frequency is close to the fp101-2, the series resonator 101-1 is in a series resonator state, an impedance value is close to the minimum, and the parallel resonator 101-2 is in a parallel resonator state, and an impedance value is close to the maximum. An input signal goes through the resonator 101-1 with the minimum attenuation, and the impedance value of the resonator 101-2 reaches a peak value, which has played an optimal isolation effect over the ground, thus the signal will go through the piezoelectric acoustic wave band-pass filter unit 101 with the minimum attenuation. The fp101-2 or fs101-1 is called a passband center frequency of the piezoelectric acoustic wave band-pass filter unit. The extremely low impedance value of the series resonator 101-1 close to the fs101-1 and the extremely high impedance value of the parallel resonator 101-2 close to the fp101-2 jointly guarantee the performance of the filter passband 311. When the input signal frequency is less than the fs101-2 or greater than the fp101-1, the resonator is equivalent to a capacitance, and a magnitude of the capacitance is decided by an area of the resonator and a distance between the top electrode and the bottom electrode of the resonator. The out-band rejection performance of the piezoelectric acoustic wave band-pass filter is mainly decided by a ratio of the area of the resonators on the parallel branch to the area of the resonators on the series branch and the number of the cascaded acoustic wave band-pass filter units.

In conclusion, the passband insertion loss performance of the radio-frequency filter with the trapezoidal structure formed by the bulk acoustic wave resonators is mainly codetermined by the impedance value of the parallel resonator on the parallel branch close to the parallel resonant frequency thereof and the impedance value of the series resonator on the series branch close to the series resonant frequency thereof.

The document EP 1478091 discloses a filter device constituted by circuit elements formed on a single substrate. The document US2008079521 discloses a piezoelectric bulk acoustic wave band-pass filter comprising a parallel resonator having a type 1 dispersion and a series resonator having a type 2 dispersion.

### Summary of the Invention

The embodiments of the present invention provides a low-insertion-loss piezoelectric acoustic wave band-pass filter and a realization method thereof, which can better solve the problem of passband insertion loss of the piezoelectric acoustic wave band-pass filter.

The above problem is solved by a method according to claim 1 and a piezoelectric acoustic wave band-pass filter according to claim 7. Further improvements and embodiments are provided in the dependent claims.

According to one embodiment of the present invention, a realization method for a low-insertion-loss piezoelectric acoustic wave band-pass filter is provided, which comprises:
using one of a first kind of piezoelectric acoustic wave resonators to constitute a series branch;
using one of a second kind of piezoelectric acoustic wave resonators to constitute a parallel branch with a ground terminal;
connecting any end of the series branch with a non-ground terminal of the parallel branch to form an acoustic wave band-pass filter unit; and
cascading a plurality of the acoustic wave band-pass filter units;
wherein an impedance value at a series resonant frequency of the first kind of piezoelectric acoustic wave resonators is less than an impedance value at a series resonant frequency of the second kind of piezoelectric acoustic wave resonators; and
an impedance value at a parallel resonant frequency of the first kind of piezoelectric acoustic wave resonators is less than an impedance value at a parallel resonant frequency of the second kind of piezoelectric acoustic wave resonators.
The series resonant frequency of the first kind of piezoelectric acoustic wave resonators is equal to the parallel resonant frequency of the second kind of piezoelectric acoustic wave resonators, or a difference absolute value between the series resonant frequency of the first kind of piezoelectric acoustic wave resonators and the parallel resonant frequency of the second kind of piezoelectric acoustic wave resonators is less than or equal to a threshold value. The first kind of piezoelectric acoustic wave resonators has an I-type acoustic dispersion characteristic, so that the impedance value of the resonators close to the series resonant frequency reaches a minimum.

Preferably, the first kind of piezoelectric acoustic wave resonators is a film bulk acoustic resonator or a solid mounted resonator. The second kind of piezoelectric acoustic wave resonators has an II-type acoustic dispersion characteristic, so that the impedance value of the resonators close to the parallel resonant frequency reaches a maximum.

Preferably, the second kind of piezoelectric acoustic wave resonators is a film bulk acoustic resonator or a solid mounted resonator.

Preferably, the first kind of piezoelectric acoustic wave resonators and the second kind of piezoelectric acoustic wave resonators have a basic stacked structure, and the basic stacked structure contains a bottom electrode layer, a piezoelectric layer and a top electrode layer.

Preferably, materials of the bottom electrode layer and the top electrode layer are one of copper, aluminum, molybdenum, platinum, gold and tungsten, and materials of the piezoelectric layer are one of aluminum nitride, zinc oxide and lead zirconate titanate.

According to another aspect of the present invention, a low-insertion-loss piezoelectric acoustic wave band-pass filter is provided, which comprises: a plurality of acoustic wave band-pass filter units which are cascaded; wherein
the acoustic wave band-pass filter unit comprises:
a series branch constituted by using one of a first kind of piezoelectric acoustic wave resonators; and
a parallel branch with a ground terminal constituted by using one of a second kind of piezoelectric acoustic wave resonators;
wherein any end of the series branch is connected with a non-ground terminal of the parallel branch;
an impedance value at a series resonant frequency of the first kind of piezoelectric acoustic wave resonators is less than an impedance value at a series resonant frequency of the second kind of piezoelectric acoustic wave resonators; and
an impedance value at a parallel resonant frequency of the first kind of piezoelectric acoustic wave resonators is less than an impedance value at a parallel resonant frequency of the second kind of piezoelectric acoustic wave resonators.
The series resonant frequency of the first kind of piezoelectric acoustic wave resonators is equal to the parallel resonant frequency of the second kind of piezoelectric acoustic wave resonators, or a difference absolute value between the series resonant frequency of the first kind of piezoelectric acoustic wave resonators and the parallel resonant frequency of the second kind of piezoelectric acoustic wave resonators is less than or equal to a threshold value.

In the embodiments of the present invention, in the condition of not affecting the out-band rejection of the piezoelectric acoustic wave band-pass filter, the passband performance can be enhanced, that is, the passband insertion loss can be reduced.

### Brief Description of Drawings

FIG. 1 is a block diagram of a traditional band-pass filter with the trapezoidal structure.
FIG. 2 is a frequency response curve diagram of the series resonator 101-1 and parallel resonator 101-2 in FIG. 1.
FIG. 3 is a frequency response curve diagram of the piezoelectric acoustic wave band-pass filter unit 101 in FIG. 1.
FIG. 4 is an acoustic dispersion curve diagram of I-type and II-type bulk acoustic wave resonators.
FIG. 5 is a frequency response curve diagram of I-type and II-type bulk acoustic wave resonators.
FIG. 6 is a block diagram of a piezoelectric acoustic wave band-pass filter with the trapezoidal structure provided in the embodiment of the present invention.
FIG. 7 is a frequency response curve diagram of the series resonator 101-1 and parallel resonator 101-2 in FIG. 1 and the series resonator 601-1 and parallel resonator 601-2 in FIG. 6.
FIG. 8 is a frequency response curve diagram of the piezoelectric acoustic wave band-pass filter unit 101 in FIG. 1 and the piezoelectric acoustic wave band-pass filter unit 601 in FIG. 6.

### Preferred Embodiments of the Invention

The preferred embodiments of the present invention will be described in detail in combination with the accompanying drawings below. It should be noted that the embodiments in the present invention and the characteristics in the embodiments can be optionally combined with each other in the condition of no conflict.

The bulk acoustic wave resonator constituting the acoustic wave band-pass filter unit shown in FIG. 1 has two kinds of acoustic dispersion characteristics in the acoustic propagation mode, which are respectively an I-type acoustic dispersion characteristic and an II-type acoustic dispersion characteristic. A bulk acoustic wave resonator with the I-type acoustic dispersion characteristic is called an I-type bulk acoustic wave resonator, and a bulk acoustic wave resonator with the II-type acoustic dispersion characteristic is called an II-type bulk acoustic wave resonator. FIG. 4 respectively shows an acoustic dispersion curve of the I-type bulk acoustic wave resonator and an acoustic dispersion curve of the II-type bulk acoustic wave resonator, wherein an ordinate represents a frequency, and an abscissa represents a propagation constant β. The left to an intersection point of the abscissa and the ordinate represents that the propagation constant is an imaginary number, and the right to the intersection point represents that the propagation constant is a real number. Each point on the dispersion curve represents a propagation constant corresponding to each working frequency of the acoustic wave resonator, the propagation constant of the imaginary number corresponds to an evanescent wave, and the propagation constant of the real number corresponds to a travelling wave. Only when a propagation constant corresponding to the acoustic wave in an area outside the electrode is an imaginary number and a propagation constant corresponding to the acoustic wave in an area inside the electrode is a real number, energy can be constrained within the electrode area of the resonator so as to generate the resonance. The acoustic dispersion curve of the I-type bulk acoustic wave resonator and the acoustic dispersion curve of the II-type bulk acoustic wave resonator are different, a TE mode in the acoustic dispersion curve of the I-type bulk acoustic wave resonator is above a corresponding TS mode, and a TE mode in the acoustic dispersion curve of the II-type bulk acoustic wave resonator is below a corresponding TS mode. Propagation modes of the internal acoustic waves are also different when the I-type bulk acoustic wave resonator and the II-type bulk acoustic wave resonator generate the resonance, and corresponding impedance values close to the series resonant frequency and the parallel resonant frequency are also different.

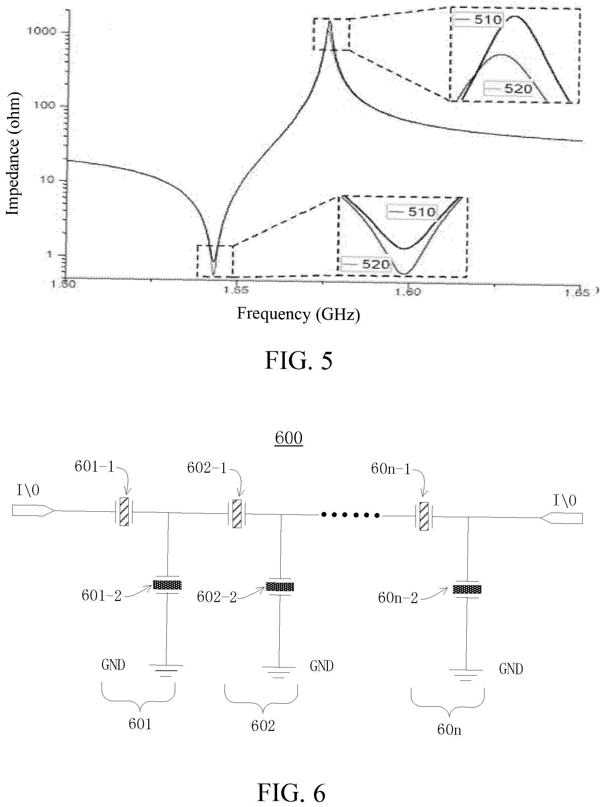

FIG. 5 shows frequency response curves of the I-type and II-type bulk acoustic wave resonators with the same resonant frequency, in the figure, an abscissa represents a frequency, and an ordinate represents an impedance value. A curve 520 represents a frequency response curve of the I-type bulk acoustic wave resonator, and a curve 510 represents a frequency response curve of the II-type bulk acoustic wave resonator. As shown in FIG. 4, the impedance value of the I-type bulk acoustic wave resonator close to the series resonant frequency is less than the impedance value of the II-type bulk acoustic wave resonator close to the series resonant frequency. The impedance value of the II-type bulk acoustic wave resonator close to the parallel resonant frequency is greater than the impedance value of the I-type bulk acoustic wave resonator close to the parallel resonant frequency.

FIG. 6 shows a piezoelectric acoustic wave band-pass filter 600 with the trapezoidal structure provided in the embodiment of the present invention, a plurality of cascaded acoustic wave band-pass filter units are included, the acoustic wave band-pass filter unit includes: a series branch constituted by using one of the first kind of piezoelectric acoustic wave resonators and a parallel branch with a ground terminal constituted by using one of the second kind of piezoelectric acoustic wave resonators, wherein any end of the series branch is connected with a non-ground terminal of the parallel branch, an impedance value at a series resonant frequency of the first kind of piezoelectric acoustic wave resonators is less than an impedance value at a series resonant frequency of the second kind of piezoelectric acoustic wave resonators; and an impedance value at a parallel resonant frequency of the first kind of piezoelectric acoustic wave resonators is less than an impedance value at a parallel resonant frequency of the second kind of piezoelectric acoustic wave resonators. The first kind of piezoelectric acoustic wave resonators and the second kind of piezoelectric acoustic wave resonators have different series resonant frequency and parallel resonant frequency, so that the series resonant frequency of the first kind of piezoelectric acoustic wave resonators is equal to or approximate to the parallel resonant frequency of the second kind of piezoelectric acoustic wave resonators (the series resonant frequency of the first kind of piezoelectric acoustic wave resonators being approximate to the parallel resonant frequency of the second kind of piezoelectric acoustic wave resonators refers to that a difference absolute value between the series resonant frequency of the first kind of piezoelectric acoustic wave resonators and the parallel resonant frequency of the second kind of piezoelectric acoustic wave resonators is less than or equal to a preset threshold value). The first kind of piezoelectric acoustic wave resonators and the second kind of piezoelectric acoustic wave resonators can be a film bulk acoustic resonator or a solid mounted resonator.

That is to say, the piezoelectric acoustic wave band-pass filter provided in the embodiment of the present invention is similar to the traditional acoustic wave band-pass filter with the trapezoidal structure, and it consists of cascaded acoustic wave band-pass filter units 601, 602, ......, 60n. The acoustic wave band-pass filter unit 601 includes a series resonator 601-1 connected on a series branch and a parallel resonator 601-2 connected on a parallel branch. The acoustic wave band-pass filter units 602, 603, ..., 60n are similar to the acoustic wave band-pass filter unit 601. The series resonators 601-1, 602-1, ..., 60n-1 and the parallel resonators 601-2, 602-2, 60n-2 constituting the acoustic wave band-pass filter units 601, 602, ..., 60n in FIG. 6 can be one of the film bulk acoustic resonator FBAR and the solid mounted resonator SMR. In FIG. 6, the series resonators 601-1, 602-1, ..., 60n-1 on the series branch are the first kind of piezoelectric acoustic wave resonators, have an I-type acoustic dispersion characteristic, and are I-type bulk acoustic wave resonators, and the impedance value of the resonators close to the series resonant frequency reaches a minimum; the parallel resonators 601-2, 602-2, 60n-2 on the parallel branch are the second kind of piezoelectric acoustic wave resonators, have an II-type acoustic dispersion characteristic, and are II-type bulk acoustic wave resonators, and the impedance value of the resonators close to the parallel resonant frequency reaches a maximum.

A realization method for the above low-insertion-loss piezoelectric acoustic wave band-pass filter includes the following steps:
using one of the first kind of piezoelectric acoustic wave resonators to constitute a series branch;
using one of the second kind of piezoelectric acoustic wave resonators to constitute a parallel branch with a ground terminal;
connecting any end of the series branch with a non-ground terminal of the parallel branch to form an acoustic wave band-pass filter unit; and
cascading a plurality of the acoustic wave band-pass filter units;
wherein an impedance value at a series resonant frequency of the first kind of piezoelectric acoustic wave resonators is less than an impedance value at a series resonant frequency of the second kind of piezoelectric acoustic wave resonators; and
an impedance value at a parallel resonant frequency of the first kind of piezoelectric acoustic wave resonators is less than an impedance value at a parallel resonant frequency of the second kind of piezoelectric acoustic wave resonators.

The series resonant frequency of the first kind of piezoelectric acoustic wave resonators is equal to or approximate to the parallel resonant frequency of the second kind of piezoelectric acoustic wave resonators.

The first kind of piezoelectric acoustic wave resonators has an I-type acoustic dispersion characteristic, so that the impedance value of the resonators close to the series resonant frequency reaches a minimum. The second kind of piezoelectric acoustic wave resonators has an II-type acoustic dispersion characteristic, so that the impedance value of the resonators close to the parallel resonant frequency reaches a maximum. The first kind of piezoelectric acoustic wave resonators and the second kind of piezoelectric acoustic wave resonators are film bulk acoustic resonators or solid mounted resonators. The first kind of piezoelectric acoustic wave resonators and the second kind of piezoelectric acoustic wave resonators have a basic stacked structure, the basic stacked structure contains a bottom electrode layer, a piezoelectric layer and a top electrode layer, wherein materials of the bottom electrode layer and the top electrode layer are one of copper, aluminum, molybdenum, platinum, gold and tungsten, and materials of the piezoelectric layer are one of aluminum nitride, zinc oxide and lead zirconate titanate.

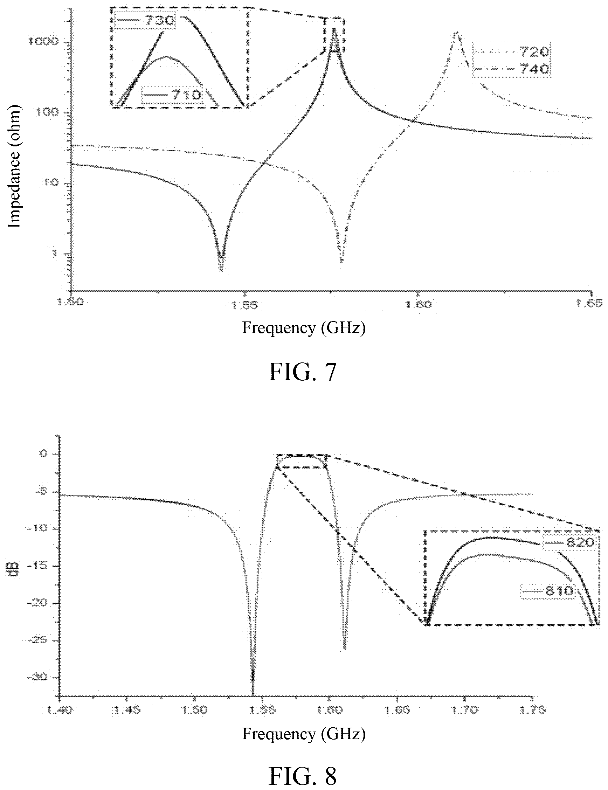

FIG. 7 shows a frequency response curve diagram of the series resonator 101-1 and parallel resonator 101-2 in FIG. 1 and the series resonator 601-1 and parallel resonator 601-2 in FIG. 6, wherein both the series resonator 101-1 and parallel resonator 101-2 being the I-type bulk acoustic wave resonators is taken as an example to be compared with the frequency response of the series resonator 601-1 and parallel resonator 601-2 of the present invention. In the figure, an abscissa represents a frequency, and an ordinate represents impedance. A curve 710 represents a frequency response curve of the parallel resonator 101-2 on the parallel branch of the traditional trapezoidal acoustic wave band-pass filter 100, and a curve 720 represents a frequency response curve of the series resonator 101-1 on the series branch of the traditional trapezoidal acoustic wave band-pass filter 100. A curve 730 represents a frequency response curve of the parallel resonator 601-2 on the parallel branch of the trapezoidal acoustic wave band-pass filter 600 of the present invention, and a curve 740 represents a frequency response curve of the series resonator 601-1 on the series branch of the trapezoidal acoustic wave band-pass filter 600 of the present invention. Compared with the resonators of the traditional trapezoidal acoustic wave band-pass filter, the impedance value of the series resonator 601-1 close to the series resonant frequency is equal to the impedance value of the series resonator 101-1 close to the series resonant frequency, but the impedance value of the parallel resonator 601-2 close to the parallel resonant frequency is greater than the impedance value of the parallel resonator 101-2 close to the parallel resonant frequency.

FIG. 8 shows a frequency response curve diagram of the piezoelectric acoustic wave band-pass filter unit 101 in FIG. 1 and the piezoelectric acoustic wave band-pass filter unit 601 in FIG. 6, wherein both the series resonator 101-1 and the parallel resonator 101-2 of the acoustic wave band-pass filter unit 101 being the I-type bulk acoustic wave resonators is taken as an example to be compared with the frequency response of the acoustic wave band-pass filter unit 601 of the present invention. A curve 810 is a frequency response curve of the acoustic wave band-pass filter unit 101 in the traditional trapezoidal piezoelectric acoustic wave band-pass filter 100 constituted by resonators which are all I-type bulk acoustic wave resonators, and a curve 820 is a frequency response curve of the acoustic wave band-pass filter unit 601 in the trapezoidal piezoelectric acoustic wave band-pass filter 600 of the present invention. In the figure, an abscissa represents a frequency, and an ordinate represents an insertion loss amplitude. As shown in FIG. 8, the out-band rejection performances of the acoustic wave band-pass filter unit 601 according to the embodiment of the present invention and the traditional acoustic wave band-pass filter unit 101 are basically the same. Meanwhile, since the impedance value of the resonator 601-2 close to the parallel resonant frequency is greater than the impedance value of the resonator 101-2 close to the parallel resonant frequency, the passband insertion loss performance of the acoustic wave band-pass filter unit 601 is superior to that of the traditional acoustic wave band-pass filter unit 101.

The acoustic dispersion curve of the resonator in the traditional trapezoidal piezoelectric acoustic wave band-pass filter 100 in FIG. 7 and FIG. 8 is not limited to the I-type, the above comparison example is only to describe that, with the structure of the acoustic wave band-pass filter of the embodiment of the present invention, by making the impedance value of the series resonator close to the series resonant frequency reach the minimum and making the impedance value of the parallel resonator close to the parallel resonant frequency reach the maximum, the insertion loss performance better than that of the traditional trapezoidal piezoelectric acoustic wave band-pass filter can be obtained.

On the whole, the embodiment of the present invention provides a piezoelectric acoustic wave band-pass filter with the trapezoidal structure constituted by a plurality of bulk acoustic wave resonators, wherein a bulk acoustic wave resonator located on the series branch has an I-type acoustic dispersion characteristic, which reduces an impedance value of the resonator close to the series resonant frequency; and a bulk acoustic wave resonator located on the parallel branch has an II-type acoustic dispersion characteristic, which increases an impedance value of the resonator close to the parallel resonant frequency. Compared with the piezoelectric acoustic wave band-pass filter with the traditional trapezoidal structure, thus better insertion loss performance is obtained in the condition of not changing the out-band rejection performance, that is, the passband insertion loss of the filter is reduced.

Though the present invention has been described in detail above, the present invention is not limited to this, and the skilled in the art can make various modifications according to the principle of the present invention. Therefore, it should be understood that all the modifications made according to the principle of the present invention fall into the protection scope of the present invention.

### Industrial Applicability

In the embodiments of the present invention, in the condition of not affecting the out-band rejection of the piezoelectric acoustic wave band-pass filter, the passband performance can be enhanced, that is, the passband insertion loss can be reduced.

## Claims

1. A realization method for a low-insertion-loss piezoelectric acoustic wave band-pass filter, comprising following steps:
using one of a first kind of piezoelectric acoustic wave resonators to constitute a series branch;
using one of a second kind of piezoelectric acoustic wave resonators to constitute a parallel branch with a ground terminal;
connecting any end of the series branch with a non-ground terminal of the parallel branch to form an acoustic wave band-pass filter unit (601); and
cascading a plurality of the acoustic wave band-pass filter units;
wherein an impedance value at a series resonant frequency of the first kind of piezoelectric acoustic wave resonators is less than an impedance value at a series resonant frequency of the second kind of piezoelectric acoustic wave resonators; an impedance value at a parallel resonant frequency of the first kind of piezoelectric acoustic wave resonators is less than an impedance value at a parallel resonant frequency of the second kind of piezoelectric acoustic wave resonators, the series resonant frequency of the first kind of piezoelectric acoustic wave resonators is equal to the parallel resonant frequency of the second kind of piezoelectric acoustic wave resonators, or a difference absolute value between the series resonant frequency of the first kind of piezoelectric acoustic wave resonators and the parallel resonant frequency of the second kind of piezoelectric acoustic wave resonators is less than or equal to a threshold value,
**characterized in that**
the first kind of piezoelectric acoustic wave resonators have an I-type acoustic dispersion characteristic and the second kind of piezoelectric acoustic wave resonators have an II-type acoustic dispersion characteristic.

2. The method according to claim 1, wherein the first kind of piezoelectric acoustic wave resonators are film bulk acoustic resonators or solid mounted resonators.

3. The method according to claim 1, wherein the second kind of piezoelectric acoustic wave resonators are film bulk acoustic resonators or solid mounted resonators.

4. The method according to any one of claims 1 to 3, wherein the first kind of piezoelectric acoustic wave resonators and the second kind of piezoelectric acoustic wave resonators have a basic stacked structure, and the basic stacked structure contains a bottom electrode layer, a piezoelectric layer and a top electrode layer.

5. The method according to claim 4, wherein materials of the bottom electrode layer and the top electrode layer are one of copper, aluminum, molybdenum, platinum, gold and tungsten, and materials of the piezoelectric layer are one of aluminum nitride, zinc oxide and lead zirconate titanate.

6. A low-insertion-loss piezoelectric acoustic wave band-pass filter, comprising: a plurality of acoustic wave band-pass filter units which are cascaded; wherein
the acoustic wave band-pass filter unit (601) comprises:
a series branch constituted by using one of a first kind of piezoelectric acoustic wave resonators; and
a parallel branch with a ground terminal constituted by using one of a second kind of piezoelectric acoustic wave resonators;
wherein any end of the series branch is connected with a non-ground terminal of the parallel branch; an impedance value at a series resonant frequency of the first kind of piezoelectric acoustic wave resonators is less than an impedance value at a series resonant frequency of the second kind of piezoelectric acoustic wave resonators; an impedance value at a parallel resonant frequency of the first kind of piezoelectric acoustic wave resonators is less than an impedance value at a parallel resonant frequency of the second kind of piezoelectric acoustic wave resonators the series resonant frequency of the first kind of piezoelectric acoustic wave resonators is equal to the parallel resonant frequency of the second kind of piezoelectric acoustic wave resonators, or a difference absolute value between the series resonant frequency of the first kind of piezoelectric acoustic wave resonators and the parallel resonant frequency of the second kind of piezoelectric acoustic wave resonators is less than or equal to a threshold value,
**characterized in that**
the first kind of piezoelectric acoustic wave resonators have an I-type acoustic dispersion characteristic and the second kind of piezoelectric acoustic wave resonators have an II-type acoustic dispersion characteristic.

7. The low-insertion-loss piezoelectric acoustic wave band-pass filter according to claim 6, wherein the first kind of piezoelectric acoustic wave resonators are film bulk acoustic resonators or solid mounted resonators.

8. The low-insertion-loss piezoelectric acoustic wave band-pass filter according to claim 6, wherein the second kind of piezoelectric acoustic wave resonators are film bulk acoustic resonators or solid mounted resonators.

9. The low-insertion-loss piezoelectric acoustic wave band-pass filter according to any one of claims 6 to 8, wherein the first kind of piezoelectric acoustic wave resonators and the second kind of piezoelectric acoustic wave resonators have a basic stacked structure, and the basic stacked structure contains a bottom electrode layer, a piezoelectric layer and a top electrode layer;
wherein materials of the bottom electrode layer and the top electrode layer are one of copper, aluminum, molybdenum, platinum, gold and tungsten, and materials of the piezoelectric layer are one of aluminum nitride, zinc oxide and lead zirconate titanate.

## Patentansprüche

1. Ausführungsverfahren für einen mit akustischen Wellen arbeitenden piezoelektrischen Bandpassfilter mit geringem Einfügungsverlust, wobei das Verfahren umfasst:
Verwenden einer ersten Art von mit akustischen Wellen arbeitenden piezoelektrischen Resonatoren, um einen Reihenzweig zu bilden;
Verwenden einer zweiten Art von mit akustischen Wellen arbeitenden piezoelektrischen Resonatoren, um einen parallelen Zweig mit einem Masseanschluss zu bilden;
Verbinden eines beliebigen Endes des Reihenzweigs mit einem Anschluss des parallelen Zweigs, der kein Masseanschluss ist, um eine mit akustischen Wellen arbeitende Bandpassfiltereinheit (601) zu bilden; und
Kaskadenschalten einer Mehrzahl von mit akustischen Wellen arbeitenden Bandpassfiltereinheiten; wobei
ein Impedanzwert an einer Reihenresonanzfrequenz der ersten Art von mit akustischen Wellen arbeitenden piezoelektrischen Resonatoren geringer ist als ein Impedanzwert an einer Reihenresonanzfrequenz der zweiten Art von mit akustischen Wellen arbeitenden piezoelektrischen Resonatoren; ein Impedanzwert an einer Parallelresonanzfrequenz der ersten Art von mit akustischen Wellen arbeitenden piezoelektrischen Resonatoren geringer ist als ein Impedanzwert an einer Parallelresonanzfrequenz der zweiten Art von mit akustischen Wellen arbeitenden piezoelektrischen Resonatoren, die Reihenresonanzfrequenz der ersten Art von mit akustischen Wellen arbeitenden piezoelektrischen Resonatoren mit der Parallelresonanzfrequenz der zweiten Art von mit akustischen Wellen arbeitenden piezoelektrischen Resonatoren gleich ist, oder ein Differenz-Absolutwert zwischen der Reihenresonanzfrequenz der ersten Art von mit akustischen Wellen arbeitenden piezoelektrischen Resonatoren und der Parallelresonanzfrequenz der zweiten Art von mit akustischen Wellen arbeitenden piezoelektrischen Resonatoren kleiner als oder gleich einem Grenzwert ist,
**dadurch gekennzeichnet, dass**
die erste Art von mit akustischen Wellen arbeitenden piezoelektrischen Resonatoren akustische Streuungseigenschaften vom Typ I aufweist, und die zweite Art von mit akustischen Wellen arbeitenden piezoelektrischen Resonatoren akustische Streuungseigenschaften vom Typ II aufweist.

2. Verfahren gemäß Anspruch 1, wobei es sich bei der ersten Art von mit akustischen Wellen arbeitenden piezoelektrischen Resonatoren um FBAR-Resonatoren oder festangebrachte Resonatoren handelt.

3. Verfahren gemäß Anspruch 1, wobei es sich bei der zweiten Art von mit akustischen Wellen arbeitenden piezoelektrischen Resonatoren um FBAR-Resonatoren oder festangebrachte Resonatoren handelt.

4. Verfahren gemäß einem der Ansprüche 1 bis 3, wobei die erste Art von mit akustischen Wellen arbeitenden piezoelektrischen Resonatoren und die zweite Art von mit akustischen Wellen arbeitenden piezoelektrischen Resonatoren eine gestapelte Grundstruktur aufweisen, und wobei die gestapelte Grundstruktur eine untere Elektrodenschicht, eine piezoelektrische Schicht und eine obere Elektrodenschicht umfasst.

5. Verfahren gemäß Anspruch 4, wobei es sich bei dem Material der unteren Elektrodenschicht und der oberen Elektrodenschicht um Kupfer, Aluminium, Molybdän, Platin, Gold oder Wolfram handelt, und wobei es sich bei dem Material der piezoelektrischen Schicht um Aluminiumnitrid, Zinkoxid oder Bleizirkonattitanat handelt.

6. Mit akustischen Wellen arbeitender piezoelektrischer Bandpassfilter mit geringem Einfügungsverlust, der umfasst: eine Mehrzahl von mit akustischen Wellen arbeitenden Bandpassfiltereinheiten, welche in Kaskade geschaltet sind; wobei
die mit akustischen Wellen arbeitende Bandpassfiltereinheit (601) umfasst:
einen Reihenzweig, der gebildet wird durch Verwenden einer ersten Art von mit akustischen Wellen arbeitenden piezoelektrischen Resonatoren; und
einen parallelen Zweig mit einem Masseanschluss, der gebildet wird durch Verwenden einer zweiten Art von mit akustischen Wellen arbeitenden piezoelektrischen Resonatoren;
wobei ein beliebiges Endes des Reihenzweigs mit einem Anschluss des parallelen Zweigs, der kein Masseanschluss ist, verbunden wird;
ein Impedanzwert an einer Reihenresonanzfrequenz der ersten Art von mit akustischen Wellen arbeitenden piezoelektrischen Resonatoren geringer ist als ein Impedanzwert an einer Reihenresonanzfrequenz der zweiten Art von mit akustischen Wellen arbeitenden piezoelektrischen Resonatoren; ein Impedanzwert an einer Parallelresonanzfrequenz der ersten Art von mit akustischen Wellen arbeitenden piezoelektrischen Resonatoren geringer ist als ein Impedanzwert an einer Parallelresonanzfrequenz der zweiten Art von mit akustischen Wellen arbeitenden piezoelektrischen Resonatoren, die Reihenresonanzfrequenz der ersten Art von mit akustischen Wellen arbeitenden piezoelektrischen Resonatoren mit der Parallelresonanzfrequenz der zweiten Art von mit akustischen Wellen arbeitenden piezoelektrischen Resonatoren gleich ist, oder ein Differenz-Absolutwert zwischen der Reihenresonanzfrequenz der ersten Art von mit akustischen Wellen arbeitenden piezoelektrischen Resonatoren und der Parallelresonanzfrequenz der zweiten Art von mit akustischen Wellen arbeitenden piezoelektrischen Resonatoren kleiner als oder gleich einem Grenzwert ist,
**dadurch gekennzeichnet, dass**
die erste Art von mit akustischen Wellen arbeitenden piezoelektrischen Resonatoren akustische Streuungseigenschaften vom Typ I aufweist, und die zweite Art von mit akustischen Wellen arbeitenden piezoelektrischen Resonatoren akustische Streuungseigenschaften vom Typ II aufweist.

7. Mit akustischen Wellen arbeitender piezoelektrischer Bandpassfilter mit geringem Einfügungsverlust gemäß Anspruch 6, wobei es sich bei der ersten Art von mit akustischen Wellen arbeitenden piezoelektrischen Resonatoren um FBAR-Resonatoren oder festangebrachte Resonatoren handelt.

8. Mit akustischen Wellen arbeitender piezoelektrischer Bandpassfilter mit geringem Einfügungsverlust gemäß Anspruch 6, wobei es sich bei der zweiten Art von mit akustischen Wellen arbeitenden piezoelektrischen Resonatoren um Dünnschichtresonatoren oder festangebrachte Resonatoren handelt.

9. Mit akustischen Wellen arbeitender piezoelektrischer Bandpassfilter mit geringem Einfügungsverlust gemäß einem der Ansprüche 6 bis 8, wobei die erste Art von mit akustischen Wellen arbeitenden piezoelektrischen Resonatoren und die zweite Art von mit akustischen Wellen arbeitenden piezoelektrischen Resonatoren eine gestapelte Grundstruktur aufweisen, und wobei die gestapelte Grundstruktur eine untere Elektrodenschicht, eine piezoelektrische Schicht und eine obere Elektrodenschicht umfasst;
wobei es sich bei dem Material der unteren Elektrodenschicht und der oberen Elektrodenschicht um Kupfer, Aluminium, Molybdän, Platin, Gold oder Wolfram handelt, und wobei es sich bei dem Material der piezoelektrischen Schicht um Aluminiumnitrid, Zinkoxid oder Bleizirkonattitanat handelt.

## Revendications

1. Procédé de réalisation d'un filtre passe-bande piézoélectrique à ondes acoustiques à faible perte d'insertion, comprenant les étapes suivantes :
l'utilisation d'un premier type de résonateurs piézoélectriques à ondes acoustiques pour constituer une branche série,
l'utilisation d'un deuxième type de résonateurs piézoélectriques à ondes acoustiques pour constituer une branche parallèle avec une borne de terre,
le branchement d'une quelconque extrémité de la branche série avec une borne autre que de terre de la branche parallèle pour former une unité de filtre passe-bande à ondes acoustiques (601), et le branchement en cascade d'une pluralité d'unités de filtre passe-bande à ondes acoustiques ; dans lequel
une valeur d'impédance à une fréquence de résonance série du premier type de résonateurs piézoélectriques à ondes acoustiques est inférieure à une valeur d'impédance à une fréquence de résonance série du deuxième type de résonateurs piézoélectriques à ondes acoustiques ; une valeur d'impédance à une fréquence de résonance parallèle du premier type de résonateurs piézoélectriques à ondes acoustiques est inférieure à une valeur d'impédance à une fréquence de résonance parallèle du deuxième type de résonateurs piézoélectriques à ondes acoustiques, la fréquence de résonance série du premier type de résonateurs piézoélectriques à ondes acoustiques est égale à la fréquence de résonance parallèle du deuxième type de résonateurs piézoélectriques à ondes acoustiques, ou une valeur absolue de différence entre la fréquence de résonance série du premier type de résonateurs piézoélectriques à ondes acoustiques et la fréquence de résonance parallèle du deuxième type de résonateurs piézoélectriques à ondes acoustiques est inférieure ou égale à une valeur seuil,
**caractérisé en ce que**
le premier type de résonateurs piézoélectriques à ondes acoustiques présente une caractéristique de dispersion acoustique de type I et le deuxième type de résonateurs piézoélectriques à ondes acoustiques présente une caractéristique de dispersion acoustique de type II.

2. Procédé selon la revendication 1, dans lequel le premier type de résonateurs piézoélectriques à ondes acoustiques consiste en des résonateurs à ondes acoustiques de volume ou des résonateurs SMR (solid mounted resonators).

3. Procédé selon la revendication 1, dans lequel le deuxième type de résonateurs piézoélectriques à ondes acoustiques consiste en des résonateurs à ondes acoustiques de volume ou des résonateurs SMR (solid mounted resonators).

4. Procédé selon l'une quelconque des revendications 1 à 3, dans lequel le premier type de résonateurs piézoélectriques à ondes acoustiques et le deuxième type de résonateurs piézoélectriques à ondes acoustiques ont une structure empilée classique, et la structure empilée classique contient une couche d'électrode de base, une couche piézoélectrique et une couche d'électrode supérieure.

5. Procédé selon la revendication 4, dans lequel la matière composant la couche d'électrode de base et la couche d'électrode supérieure est le cuivre, l'aluminium, le molybdène, le platine, l'or ou le tungstène, et la matière composant la couche piézoélectrique est le nitrure d'aluminium, l'oxyde de zinc ou le titano-zirconate de plomb.

6. Filtre passe-bande piézoélectrique à ondes acoustiques à faible perte d'insertion, comprenant :
une pluralité d'unités de filtre passe-bande à ondes acoustiques qui sont branchées en cascades ; dans lequel
l'unité de filtre passe-bande à ondes acoustiques (601) comprend :
une branche série constituée par l'utilisation d'un premier type de résonateurs piézoélectriques à ondes acoustiques, et
une branche parallèle avec une borne de terre constituée par l'utilisation d'un deuxième type de résonateurs piézoélectriques à ondes acoustiques,
dans lequel une quelconque extrémité de la branche série est branchée avec une borne autre que de terre de la branche parallèle,
une valeur d'impédance à une fréquence de résonance série du premier type de résonateurs piézoélectriques à ondes acoustiques est inférieure à une valeur d'impédance à une fréquence de résonance série du deuxième type de résonateurs piézoélectriques à ondes acoustiques ; une valeur d'impédance à une fréquence de résonance parallèle du premier type de résonateurs piézoélectriques à ondes acoustiques est inférieure à une valeur d'impédance à une fréquence de résonance parallèle du deuxième type de résonateurs piézoélectriques à ondes acoustiques, la fréquence de résonance série du premier type de résonateurs piézoélectriques à ondes acoustiques est égale à la fréquence de résonance parallèle du deuxième type de résonateurs piézoélectriques à ondes acoustiques, ou une valeur absolue de différence entre la fréquence de résonance série du premier type de résonateurs piézoélectriques à ondes acoustiques et la fréquence de résonance parallèle du deuxième type de résonateurs piézoélectriques à ondes acoustiques est inférieure ou égale à une valeur seuil,
**caractérisé en ce que**
le premier type de résonateurs piézoélectriques à ondes acoustiques présente une caractéristique de dispersion acoustique de type I et le deuxième type de résonateurs piézoélectriques à ondes acoustiques présente une caractéristique de dispersion acoustique de type II.

7. Filtre passe-bande piézoélectrique à ondes acoustiques à faible perte d'insertion selon la revendication 6, dans lequel le premier type de résonateurs piézoélectriques à ondes acoustiques consiste en des résonateurs à ondes acoustiques de volume ou des résonateurs SMR (solid mounted resonators).

8. Filtre passe-bande piézoélectrique à ondes acoustiques à faible perte d'insertion selon la revendication 6, dans lequel le deuxième type de résonateurs piézoélectriques à ondes acoustiques consiste en des résonateurs à ondes acoustiques de volume ou des résonateurs SMR (solid mounted resonators).

9. Filtre passe-bande piézoélectrique à ondes acoustiques à faible perte d'insertion selon l'une quelconque des revendications 6 à 8, dans lequel le premier type de résonateurs piézoélectriques à ondes acoustiques et le deuxième type de résonateurs piézoélectriques à ondes acoustiques ont une structure empilée classique, et la structure empilée classique contient une couche d'électrode de base, une couche piézoélectrique et une couche d'électrode supérieure ;
dans lequel la matière composant la couche d'électrode de base et la couche d'électrode supérieure est le cuivre, l'aluminium, le molybdène, le platine, l'or ou le tungstène, et la matière composant la couche piézoélectrique est le nitrure d'aluminium, l'oxyde de zinc ou le titano-zirconate de plomb.
